# EUROPEAN PATENT APPLICATION

(11) **EP 4 626 168 A1**
(43) Date of publication of application: **01.10.2025**
(21) Application number: 25159193.9
(22) Date of filing: 20.02.2025
(51) Int. Cl.: H10D 30/01, H10D 30/00, H10D 62/13, H10D 62/822, H10D 64/01

(54) **GATE-ALL-AROUND TRANSISTOR WITHOUT CAVITY SPACER STRUCTURES**

(30) Priority: 28.03.2024 US 202418619739
(71) Applicant: Intel Corporation, Santa Clara, CA 95054 (US)
(72) Inventor: JUN, Hwichan, Portland, OR 97229 (US); BOUCHE, Guillaume, Portland, OR 97217 (US); GUHA NEOGI, Tuhin, Sherwood, OR 97140 (US); CHARUE-BAKKER, Sandrine, Portland, OR 97229 (US); EHLERT, Robert, Portland, OR 97229 (US)
(74) Representative: HGF

(57) **Abstract**

Techniques are provided herein to form an integrated circuit having a semiconductor layer separating gate structures from source or drain regions instead of dielectric spacers. A FET (field effect transistor) includes a gate structure having a gate electrode on a gate dielectric. The gate structure extends around any number of nanoribbons of semiconductor material. The nanoribbons may extend in a first direction between source and drain regions while the gate structure extends over the nanoribbons in a second direction. A semiconductor layer separates the gate structure from contacting the source or drain region between adjacent nanoribbons. The semiconductor layer extends in a third direction between the gate structure and the source or drain regions and also between the nanoribbons and the source or drain regions. The source or drain regions may be epitaxially grown on the semiconductor layer.

## Description

### BACKGROUND

As integrated circuits continue to scale downward in size, a number of challenges arise. For instance, reducing the size of memory and logic cells within the interconnect structure is becoming increasingly more difficult, as is reducing device spacing at the device layer. Maintaining a certain level of quality among the various transistor elements can be a challenge due to the number of different fabrication processes they may be subjected to. Additionally, process variation across such a large number of devices on the same die can lead to low device yields. Accordingly, there remain a number of non-trivial challenges with respect to forming such high-density semiconductor devices.

### BRIEF DESCRIPTION OF THE DRAWINGS

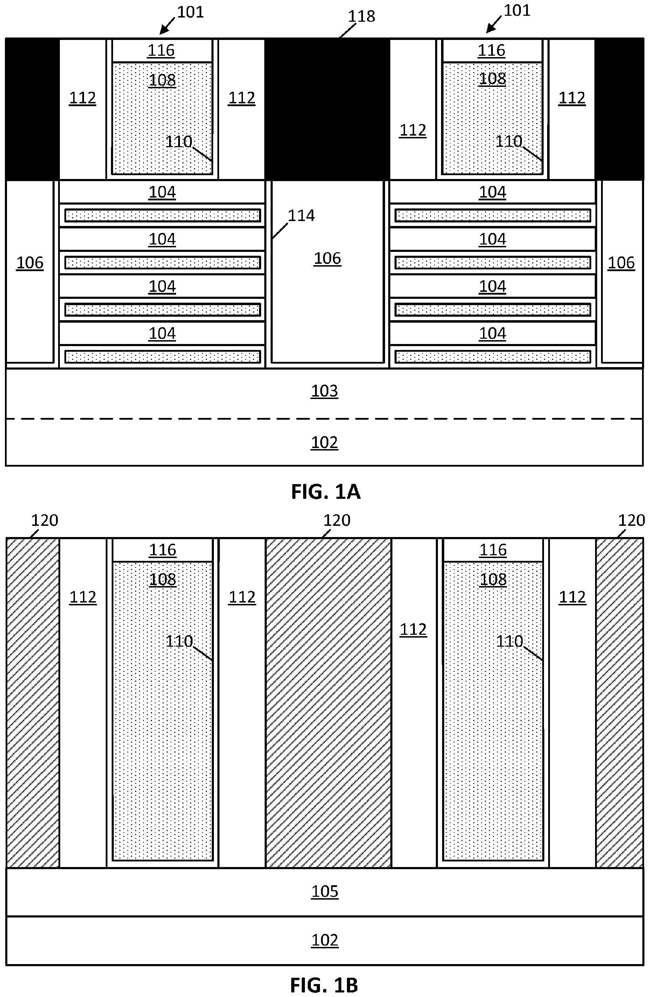

Figures 1A and 1B are different cross-sectional views of an integrated circuit that includes semiconductor devices with a semiconductor layer separating gate structures from source or drain regions, in accordance with an embodiment of the present disclosure.

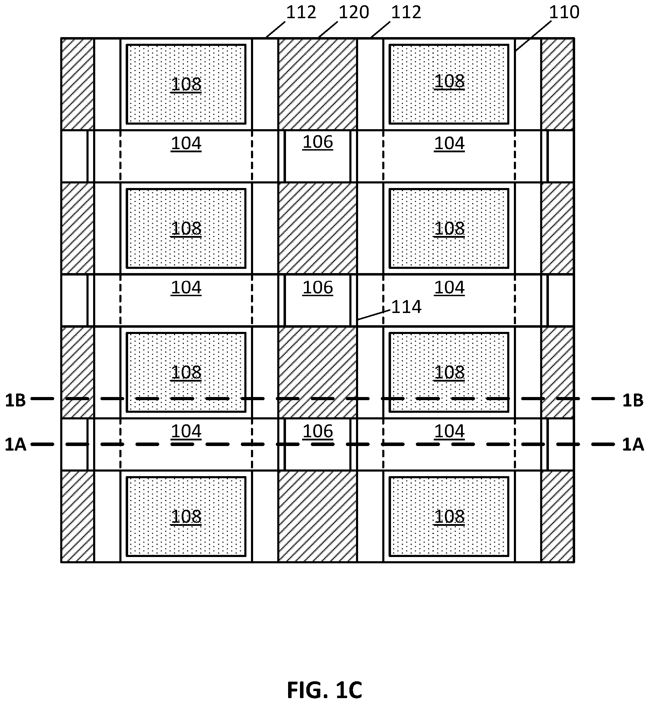

Figure 1C illustrates a plan view of the semiconductor devices shown in Figures 1A and 1B, in accordance with an embodiment of the present disclosure.

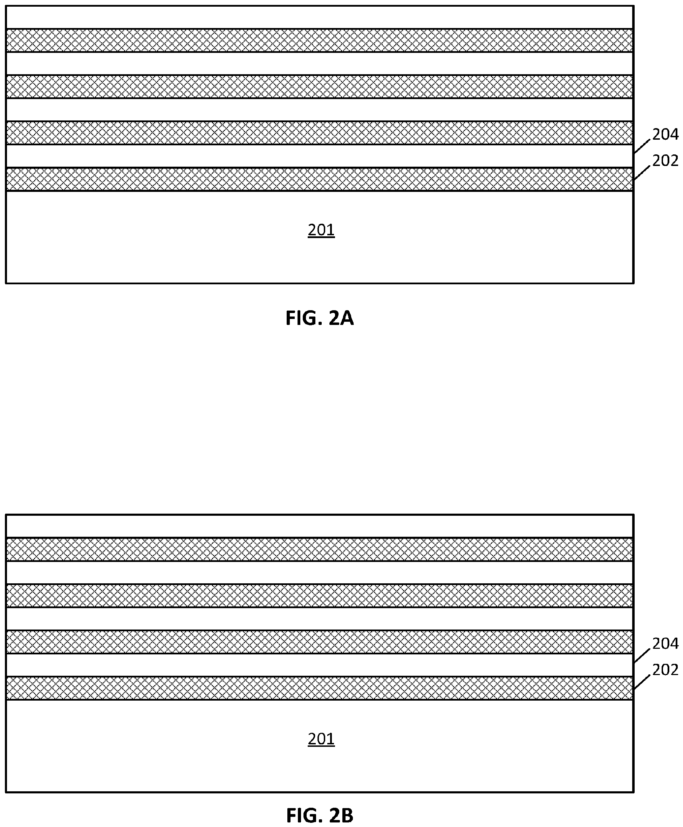

Figures 2A and 2B are cross-sectional views that illustrate one stage in an example process for forming an integrated circuit that includes semiconductor devices with a semiconductor layer separating gate structures from source or drain regions, in accordance with an embodiment of the present disclosure.

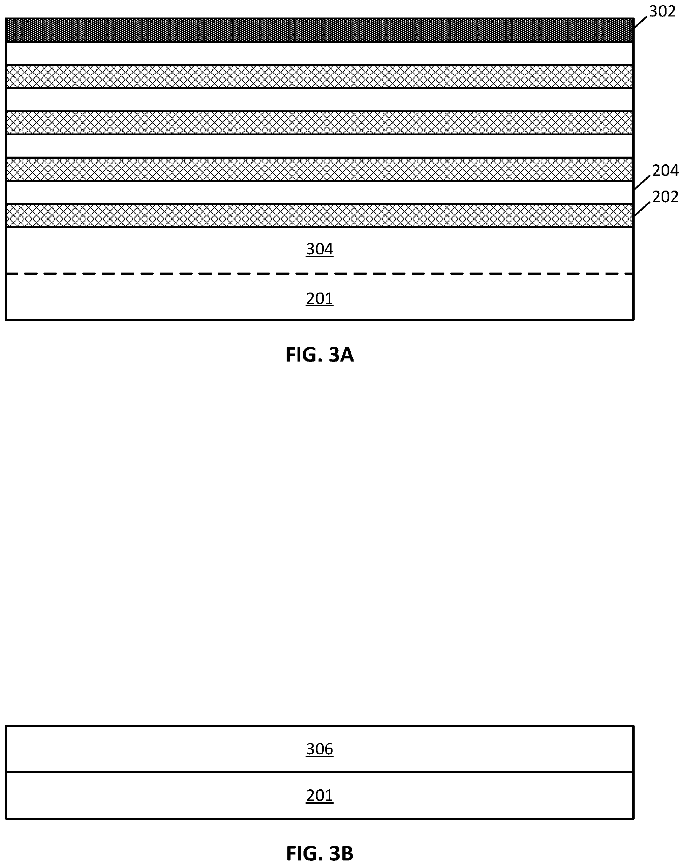

Figures 3A and 3B are cross-sectional views that illustrate another stage in the example process for forming an integrated circuit that includes semiconductor devices with a semiconductor layer separating gate structures from source or drain regions, in accordance with an embodiment of the present disclosure.

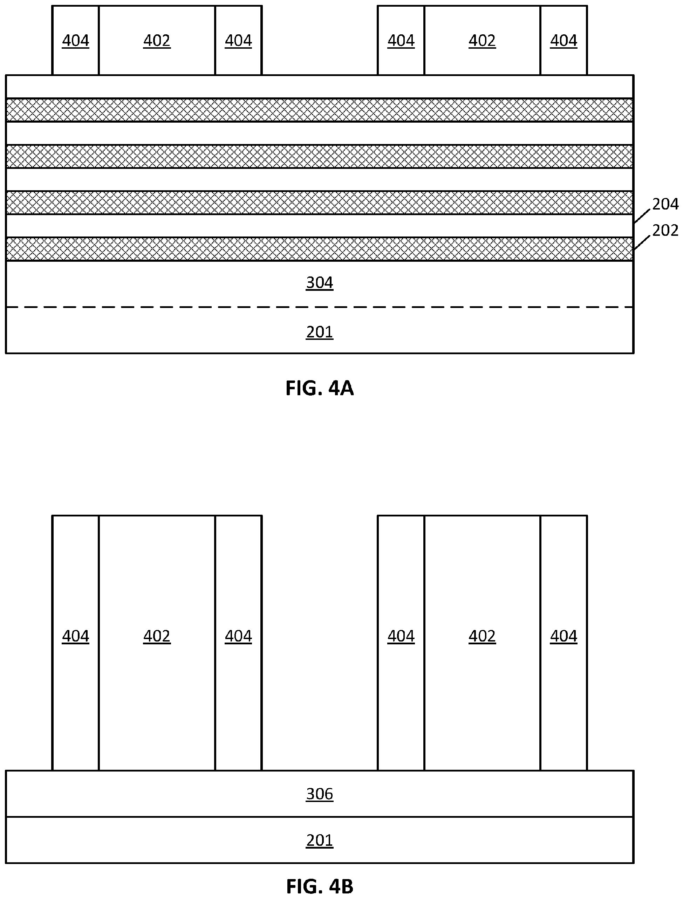

Figures 4A and 4B are cross-sectional views that illustrate another stage in the example process for forming an integrated circuit that includes semiconductor devices with a semiconductor layer separating gate structures from source or drain regions, in accordance with an embodiment of the present disclosure.

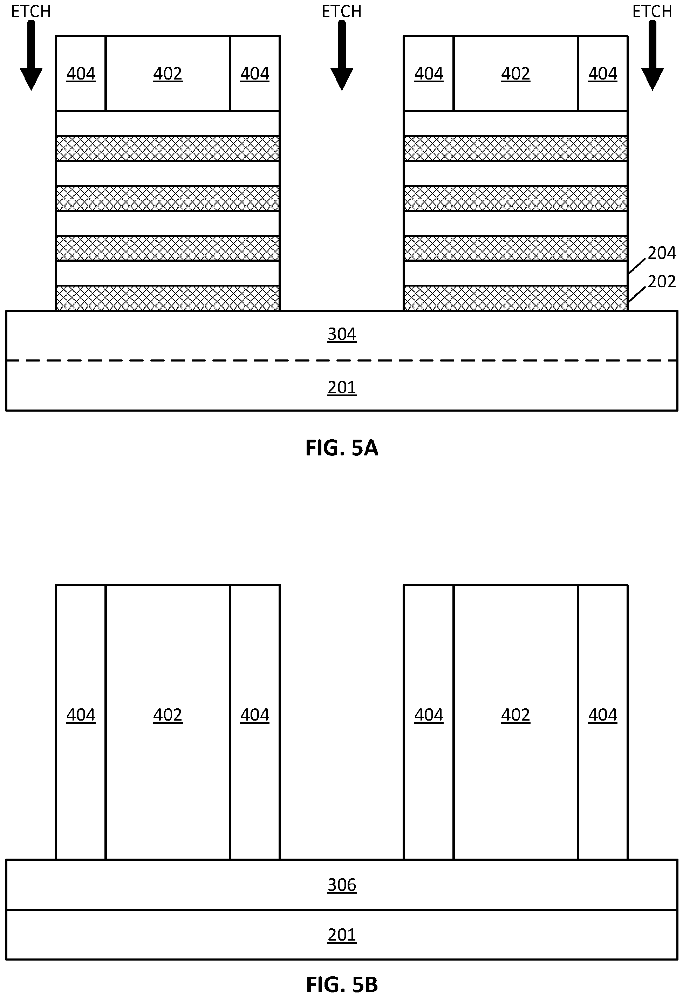

Figures 5A and 5B are cross-sectional views that illustrate another stage in the example process for forming an integrated circuit that includes semiconductor devices with a semiconductor layer separating gate structures from source or drain regions, in accordance with an embodiment of the present disclosure.

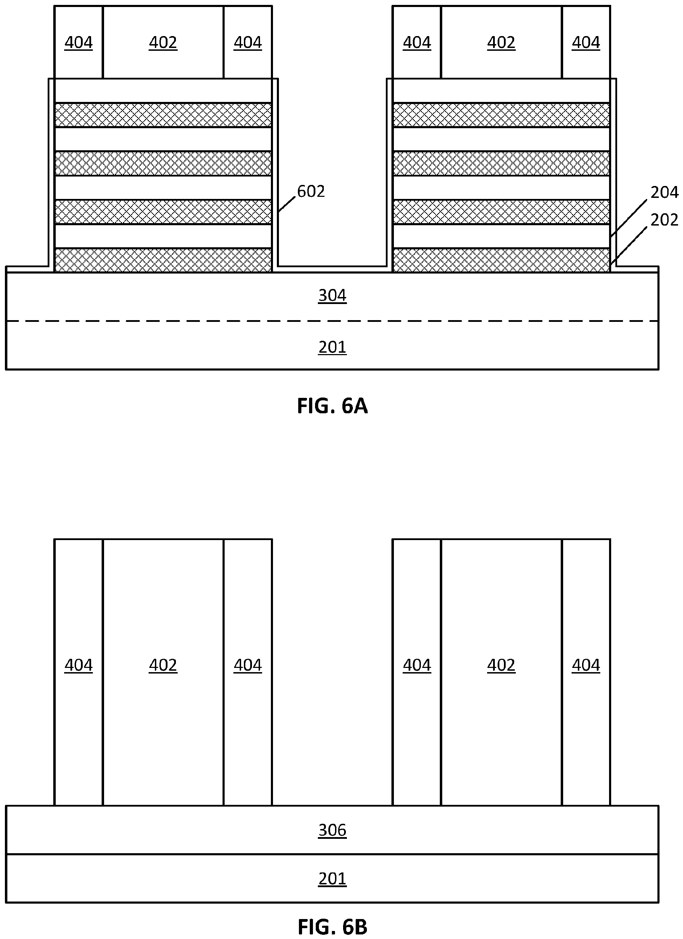

Figures 6A and 6B are cross-sectional views that illustrate another stage in the example process for forming an integrated circuit that includes semiconductor devices with a semiconductor layer separating gate structures from source or drain regions, in accordance with an embodiment of the present disclosure.

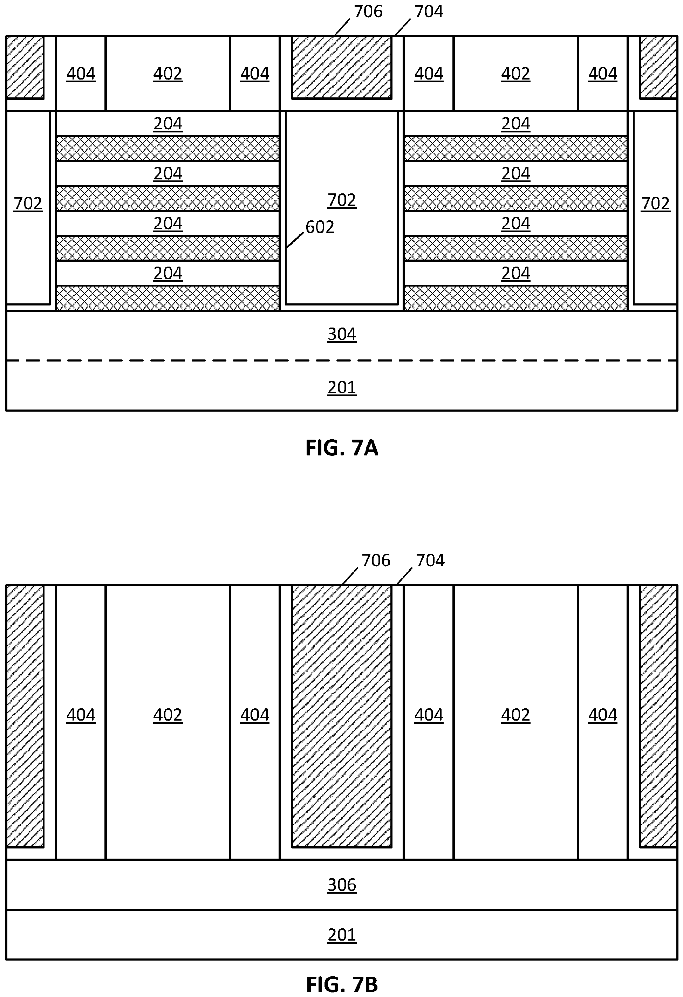

Figures 7A and 7B are cross-sectional views that illustrate another stage in the example process for forming an integrated circuit that includes semiconductor devices with a semiconductor layer separating gate structures from source or drain regions, in accordance with an embodiment of the present disclosure.

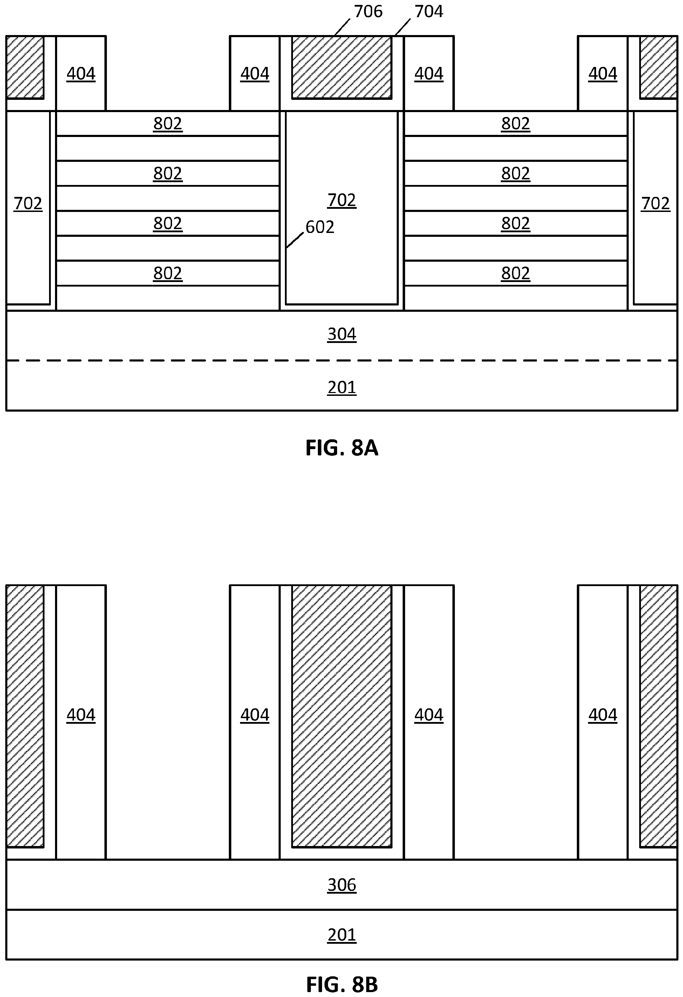

Figures 8A and 8B are cross-sectional views that illustrate another stage in the example process for forming an integrated circuit that includes semiconductor devices with a semiconductor layer separating gate structures from source or drain regions, in accordance with an embodiment of the present disclosure.

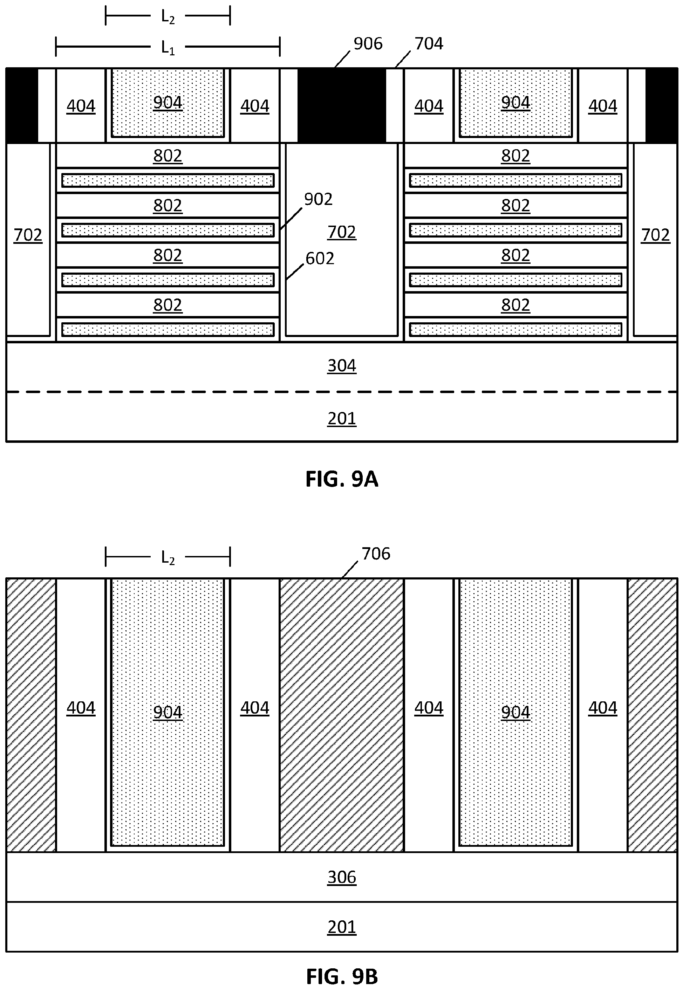

Figures 9A and 9B are cross-sectional views that illustrate another stage in the example process for forming an integrated circuit that includes semiconductor devices with a semiconductor layer separating gate structures from source or drain regions, in accordance with an embodiment of the present disclosure.

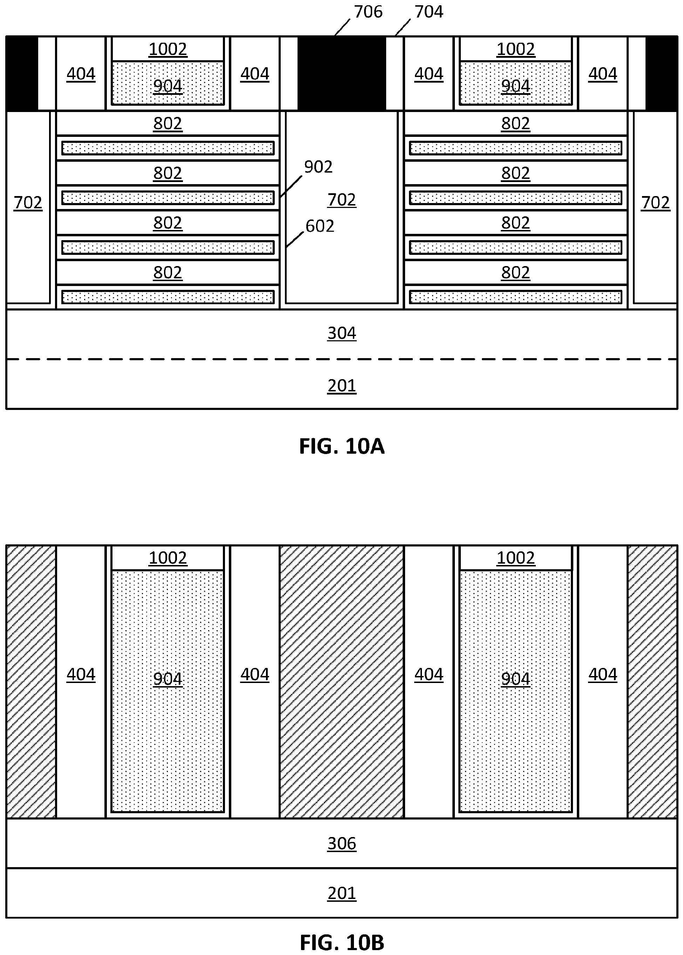

Figures 10A and 10B are cross-sectional views that illustrate another stage in the example process for forming an integrated circuit that includes semiconductor devices with a semiconductor layer separating gate structures from source or drain regions, in accordance with an embodiment of the present disclosure.

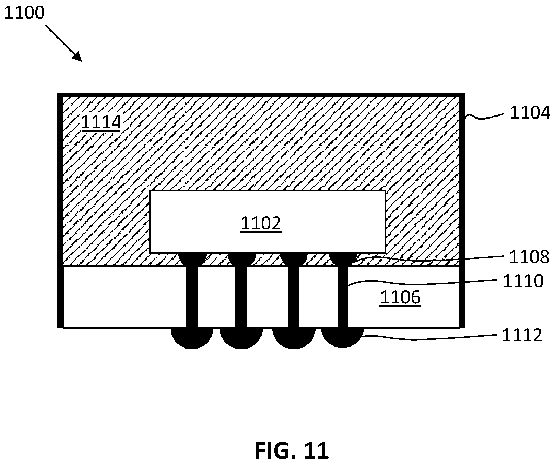

Figure 11 illustrates a cross-sectional view of a chip package containing one or more semiconductor dies, in accordance with some embodiments of the present disclosure.

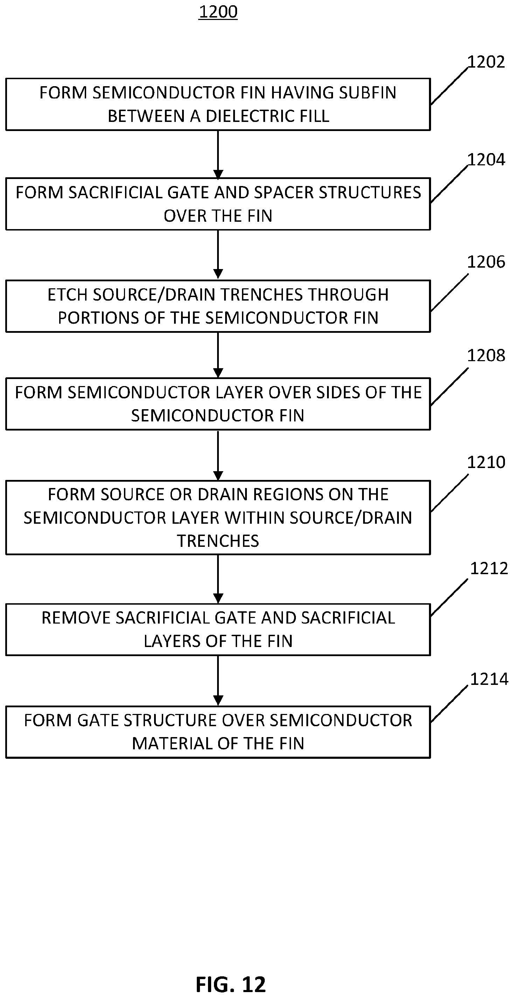

Figure 12 is a flowchart of a fabrication process for an integrated circuit that includes semiconductor devices with a semiconductor layer separating gate structures from source or drain regions, in accordance with an embodiment of the present disclosure.

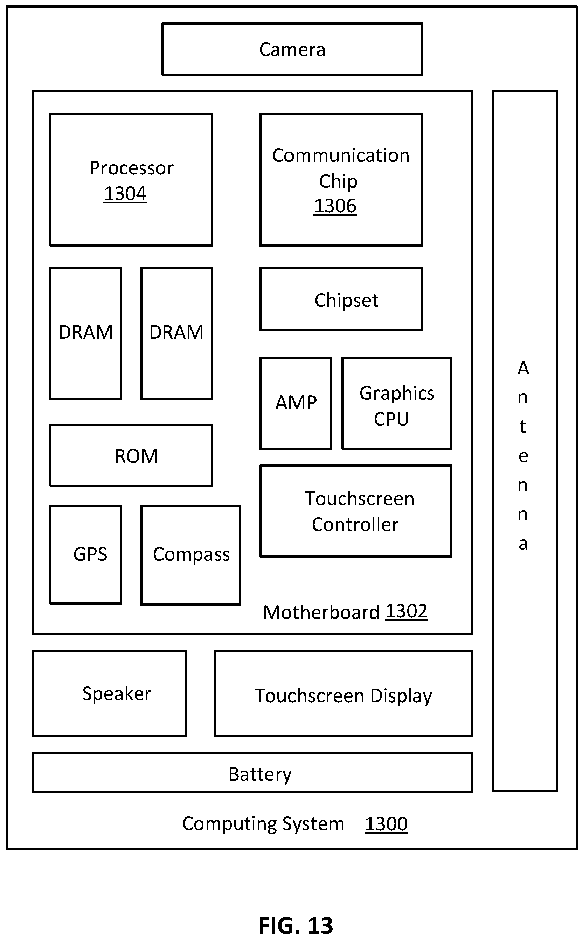

Figure 13 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form an integrated circuit having a layer of semiconductor material separating gate structures from source or drain regions instead of (or in addition to) dielectric spacers. The techniques can be used in any number of integrated circuit applications and are particularly useful with respect to logic and memory cells, such as those cells that use gate-all-around transistors (e.g., ribbonFETs and nanowire FETs) or fork sheet transistors. In one such example, a FET (field effect transistor) includes a gate structure having a gate electrode on a gate dielectric. The gate structure extends around any number of nanoribbons (or nanowires or nanosheets, as the case may be) of semiconductor material. The nanoribbons may extend in a first direction (e.g., along x-axis) between source and drain regions while the gate structure extends over the nanoribbons in a second direction (e.g., along y-axis) substantially orthogonal to the first direction. A continuous layer of semiconductor material effectively lines each of the source and drain recesses, such that each layer separates the gate structure from contacting the corresponding source or drain region, and is also on corresponding ends of the semiconductor nanoribbons, such that the semiconductor layer extends in a third direction (e.g., along z-axis, and substantially orthogonal to the first and second directions) between the gate structure and the source or drain regions and between the nanoribbons and the source or drain regions. In some examples, the source or drain regions are epitaxially grown on the semiconductor layer. Numerous variations and embodiments will be apparent in light of this disclosure.

### General Overview

As previously noted above, there remain a number of non-trivial challenges with respect to integrated circuit fabrication. In more detail, gate-all-around (GAA) devices need to isolate the gate structure from the source or drain regions after removing the sacrificial layers within the fin structure. This isolation is provided by forming dielectric plugs (also known as internal gate spacers) near the ends of the semiconductor layers so as to create an insulating barrier between the gate trench (e.g., where the gate structure is formed) and the source/drain trench (e.g., where the source or drain regions are formed). However, the fabrication process for forming the dielectric plugs can lead to process variation across a wafer of devices, or even across a single die of devices. As a result of the process variation, some devices may have smaller plugs compared to other devices, which causes gate length variation and other yield issues.

Thus, and in accordance with an embodiment of the present disclosure, techniques are provided herein to isolate the gate structures from adjacent source or drain regions without using the aforementioned cavity spacers. According to an embodiment, a semiconductor layer is formed within the source and drain recesses (e.g., prior to epitaxial deposition of source and drain regions) to line the exposed ends of the sacrificial and semiconductor layers of a given fin before the formation of the source or drain regions. The semiconductor layer includes a material having a high etch selectivity relative to the material of the sacrificial layers in the fin. For example, if the sacrificial layers are silicon germanium (SiGe), then the semiconductor layer can be silicon. The semiconductor layer may be epitaxially grown on the exposed ends of the semiconductor fin (which, prior to liberation of nanoribbons making up the channel region, includes both semiconductor sacrificial layers and semiconductor layers). A source or drain region may be epitaxially grown on the semiconductor layer, which can yield a more robust structure compared to growth only from the ends of the semiconductor layers.

Once the sacrificial layers within the channel region have been removed (e.g., during final gate processing) to leave behind semiconductor nanoribbons (or nanosheets in a forksheet architecture), the semiconductor layer also remains on and continuous along the entire sidewall of the source or drain regions (in the z-axis or height direction), including along the spaces between the nanoribbons where the sacrificial layers once resided. Accordingly, the semiconductor layer protects the source or drain regions during the removal of the sacrificial layers. Following the formation of a gate structure over the nanoribbons, the semiconductor layer remains between the gate structure and the source or drain regions and also remains between ends of the nanoribbons and the source or drain regions.

According to an embodiment, an integrated circuit includes one or more semiconductor nanoribbons (or other bodies of semiconductor material) extending in a first direction (channel direction), and a gate structure extending in a second direction (gate direction) over the one or more semiconductor nanoribbons. The integrated circuit structure further includes a layer of semiconductor material (e.g., layer of silicon) extending in a third direction (height direction) along a side of the one or more semiconductor nanoribbons and a side of the gate structure, and a source or drain region on the semiconductor layer. The side of the one or more semiconductor nanoribbons may be substantially coplanar with the side of the gate structure, which is in contrast to an integrated circuit structure having internal gate spacers that cause the nanoribbon sides to be outwardly offset from the inwardly spaced sides of the gate structure. The semiconductor layer is between the source or drain region and the semiconductor region along the first direction and the semiconductor layer is between the source or drain region and the gate structure along the first direction.

According to another embodiment, an integrated circuit includes one or more semiconductor nanoribbons extending in a first direction, a gate structure extending in a second direction over the one or more semiconductor nanoribbons, a first layer of semiconductor material extending in a third direction along a first side of the one or more semiconductor nanoribbons and a first side of the gate structure, and a second layer of semiconductor material extending in a third direction along a second side of the one or more semiconductor nanoribbons and a second side of the gate structure. The gate structure extends along the first direction between the first layer and the second layer and contacts both the first layer and the second layer.

According to an embodiment, a method of forming an integrated circuit includes: forming a fin comprising layers of first semiconductor material alternating with layers of second semiconductor material, the fin extending above a substrate and extending lengthwise along a first direction; forming a semiconductor layer over sidewalls of the fin; forming source or drain regions on the semiconductor layer at the sidewalls of the fin; removing the layers of second semiconductor material from the fin; and forming a gate structure extending in a second direction over the layers of first semiconductor material, wherein the gate structure contacts the semiconductor layer.

According to another embodiment, an electronic device includes a chip package having one or more dies. At least one of the one or more dies includes a semiconductor device having one or more semiconductor bodies (e.g., nanoribbons, nanowire, or nanosheets) extending in a first direction, a source or drain region, and a gate structure extending in a second direction over the one or more semiconductor bodies. The at least one of the one or more dies also includes a semiconductor layer extending in a third direction along a side of the one or more semiconductor bodies and a side of the gate structure. The side of the one or more semiconductor bodies is substantially coplanar with the side of the gate structure. The semiconductor layer is between the source or drain region and the semiconductor region along the first direction, and the semiconductor layer is between the source or drain region and the gate structure along the first direction.

The techniques can be used with any type of planar or non-planar transistors, including nanowire and nanoribbon transistors (sometimes called gate-all-around transistors) or forksheet transistors, to name a few examples. The source and drain regions can be, for example, epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a replacement metal gate, or RMG, process), or any other gate formation process. Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate the presence of a semiconductor layer (e.g., less than 3 nm thick) extending continuously along a side of the source or drain region, such that the semiconductor layer also contacts ends of the nanoribbons and portions of the gate structure (e.g., the gate dielectric of the gate structure). The gate structure around the nanoribbons may also be observed as extending along the first direction between a first semiconductor layer on a first source or drain region and a second semiconductor layer on a second source or drain region. The gate structure may contact both the first and second semiconductor layers. The sides of the gate structure may also be observed to be coplanar with ends of the nanoribbons or other semiconductor bodies making up the channel region.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the material has an element that is not in the other material.

### Architecture

Figure 1A is a cross-section view taken through various semiconductor devices 101 along a 'fin' direction that illustrates the semiconductor bodies extending between source or drain regions of each semiconductor device 101, in accordance with an embodiment of the present disclosure. Figure 1B illustrates a cross-section view taken parallel to the cross-section from Figure 1A and into the page (or out of the page, as the case may be), such that it is away from the semiconductor bodies of the transistors but still crosses the gate structures extending over the semiconductor bodies. Each of the semiconductor devices may be, for instance, non-planar metal oxide semiconductor (MOS) transistors, such as gate-all-around (GAA) transistors, although other transistor topologies and types could also benefit from the techniques provided herein. The examples herein illustrate semiconductor devices with a GAA structure (e.g., having nanoribbons or nanowires that extend between source and drain regions). Other examples may have a forksheet structure having two devices separated by a dielectric spine or structure.

The semiconductor material used in each of the semiconductor devices may be formed from a semiconductor substrate 102. Substrate 102 can be, for example, a bulk substrate including group IV semiconductor material (such as silicon, germanium, or SiGe), group III-V semiconductor material (such as gallium arsenide, indium gallium arsenide, or indium phosphide), and/or any other suitable material upon which transistors can be formed. Alternatively, the substrate can be a semiconductor-on-insulator substrate having a desired semiconductor layer over a buried insulator layer (e.g., silicon over silicon dioxide). Alternatively, the substrate can be a multilayer substrate or superlattice suitable for forming nanowires or nanoribbons (e.g., alternating layers of silicon and SiGe, or alternating layers indium gallium arsenide and indium phosphide). Any number of substrates can be used. In some embodiments, substrate 102 is removed and replaced with one or more backside interconnect layers to form backside signal and power routing.

The one or more semiconductor regions of the devices may include fins that can be, for example, native to substrate 102 (formed from the substrate itself), such as silicon fins etched from a bulk silicon substrate. Alternatively, the fins can be formed of material deposited onto substrate 102. In some embodiments, the fins include alternating layers of material (e.g., alternating layers of silicon and SiGe) that facilitates forming of nanowires and nanoribbons and nanosheets during a gate forming process where one type of the alternating layers is selectively etched away so as to liberate the other type of alternating layers within the channel region, so that a gate-all-around process or a forksheet gate process can then be carried out. Again, the alternating layers can be blanket deposited and then etched into fins or deposited into fin-shaped trenches, in some examples.

According to some embodiments, semiconductor devices 101 include a subfin region 103 that extends in the first direction beneath semiconductor devices 101. According to some embodiments, subfin region 103 is a portion of the corresponding semiconductor fin that remains after formation of the various transistors and may be formed from substrate 102. Accordingly, subfin region 103 may include the same semiconductor material as substrate 102 (or any semiconductor material in situations where substrate 102 is removed).

Each semiconductor device 101 includes one or more semiconductor regions (also called channel regions), such as one or more nanoribbons 104 extending between epitaxial source or drain regions 106 in the first direction. A gate structure extends over the one or more semiconductor regions (e.g., nanoribbons 104) of a given semiconductor device 101 in a second direction (e.g., into and out of the page) to form the transistor gate. Subfin region 103 may extend along the first direction beneath one or more nanoribbons 104 and be flanked by a dielectric fill 105 in areas not beneath one or more nanoribbons 104, as shown in Figure 1B. Accordingly, dielectric fill 105 may act as shallow trench isolation (STI) between adjacent subfins along the second direction (e.g., into and out of the page).

Any of source or drain regions 106 may act as either a source region or a drain region, depending on the application and dopant profile. Any semiconductor materials suitable for source and drain regions can be used (e.g., group IV and group III-V semiconductor materials) for any of the illustrated source or drains regions 106. In any such cases, the composition and doping of source or drain regions 106 may be the same or different, depending on the polarity of the transistors. For example, any semiconductor devices that are p-channel transistors have a high concentration of p-type dopants in the associated source or drain regions 106, and any semiconductor devices that are n-channel transistors have a high concentration of n-type dopants in the associated source or drain regions 106. Example p-type dopants include boron and example n-type dopants include phosphorous. Any number of source and drain configurations and materials can be used. In some examples, n-type source or drain regions include silicon doped with phosphorous and p-type source or drain regions include silicon germanium doped with boron.

The gate structure may include a gate electrode 108 and a gate dielectric 110 that may represent any number of dielectric layers. Gate electrode 108 may include any sufficiently conductive material such as a metal, metal alloy, or doped polysilicon. In some examples, gate electrode 108 includes tungsten (W), although other metals or conductive materials may be used, such as aluminum (Al), ruthenium (Ru), cobalt (Co), or doped polysilicon. In some embodiments, gate electrode 108 includes any number of workfunction metals that can be different depending on whether devices 101 are n-channel or p-channel devices. Example work function metals include tantalum nitride (TaN) and titanium nitride (TiN).

Gate dielectric 110 may include any suitable gate dielectric material(s). In some embodiments, gate dielectric 110 includes a layer of native oxide material (e.g., silicon dioxide germanium dioxide, or SiGe oxide) on nanoribbons 104 or other semiconductor regions, and a layer of high-k dielectric material (e.g., hafnium oxide or aluminum oxide) on the native oxide. According to some embodiments, spacer structures 112 are present along the sidewalls of the gate structures. Spacer structures 112 may be any suitable dielectric material, such as silicon nitride, and provide separation between a given gate structure and the adjacent source/drain trench.

According to some embodiments, spacer structures 112 are not present between nanoribbons 104. Accordingly, the gate structures extend around nanoribbons 104 and along the first direction beneath spacer structures 112. According to some embodiments, the gate structures between the nanoribbons 104 are separated from the source or drain regions 106 by a semiconductor liner 114. In some examples, semiconductor liner 114 is the same semiconductor material as nanoribbons 104, although any suitable semiconductor material can be used. Semiconductor liner 114 may be silicon. According to an embodiment, semiconductor liner 114 extends along a side of nanoribbons 104 and along a side of the gate structure, with the sides of the nanoribbons 104 and gate structure being substantially coplanar along a third (e.g., vertical or height) direction. As a result, semiconductor liner 114 is between the gate structure and source or drain regions 106 along the first direction and is also between nanoribbons 104 and source or drain regions 106 along the first direction.

In some examples, semiconductor liner 114 has a thickness of less than 3 nm or between 1 and 2 nm. According to some embodiments, semiconductor liner 114 is present on side and bottom surfaces of the source/drain trench and is thus on a bottom surface of source or drain region 106. Gate dielectric 110 may be directly on semiconductor liner 114, such that gate dielectric 110 is directly between semiconductor liner 114 and gate electrode 108. According to some embodiments, semiconductor liner 114 is not present within the source/drain trench at locations that are away from nanoribbons 104 along the second direction, as observed in the cross-section of Figure 1B.

According to some embodiments, a dielectric cap layer 116 may be present over gate electrode 108 within the gate trenches of semiconductor devices 101. A top surface of dielectric cap layer 116 may be substantially coplanar with a top surface of spacer structures 112. Dielectric cap layer 116 may include the same dielectric material as spacer structures 112, in some examples.

According to some embodiments, conductive contacts 118 are provided on source or drain regions 106 Conductive contacts 118 can include any suitable conductive material, such as tungsten, molybdenum, ruthenium, cobalt, or other metals. Conductive contacts 118 may be formed together such that they all include the same conductive material.

As shown in Figure 1B, dielectric fill 120 may be present within the source/drain trenches to separate source or drain regions 106 from other source or drain regions along the second direction (e.g., into and out of the page), according to some embodiments. Dielectric fill 120 may be any suitable dielectric material, such as silicon dioxide, silicon oxynitride, or silicon oxycarbide.

Figure 1C illustrates a plan view of the integrated circuit, with the cross-section view of Figure 1A being across the 1A-1A dashed line and the cross-section view of Figure 1B being across the 1B-1B dashed line. Silicon liner 114 is shown on the sidewalls of source or drain regions 106, however silicon liner 114 is not present on the sidewalls of other portions of the source/drain trench away from nanoribbons 104.

### Fabrication Methodology

Figures 2A 10A and 2B - 10B include cross-sectional views that collectively illustrate an example process for forming an integrated circuit that includes semiconductor devices with a semiconductor layer separating gate structures from source or drain regions, in accordance with an embodiment of the present disclosure. Figures 2A - 10A represent a similar cross-sectional view as that of Figure 1A across a series of semiconductor devices, while Figures 2B - 10B represent a similar cross-sectional view as that of Figure 1B parallel to the view in Figures 2A -10A and away from the semiconductor devices. Each set of figures sharing the same letter shows an example structure that results from the process flow up to that point in time, so the depicted structure evolves as the process flow continues, culminating in the structure shown in Figures 10A 10B, which is similar to the structure shown in Figures 1A and 1B. Such a structure may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but other materials and process parameters may be used as well, as will be appreciated in light of this disclosure.

Figures 2A and 2B each illustrates a cross-sectional view taken through a substrate 201 having a series of material layers formed over a substrate, according to an embodiment of the present disclosure. Alternating material layers may be deposited over substrate 201 including sacrificial layers 202 alternating with semiconductor layers 204. The alternating layers are used to form GAA transistor structures. Any number of alternating sacrificial layers 202 and semiconductor layers 204 may be deposited over substrate 201. Substrate 201 may be substantially similar to substrate 102 described above.

According to some embodiments, semiconductor layers 204 have a different material composition than sacrificial layers 202. In some embodiments, semiconductor layers 204 include a semiconductor material suitable for use as a nanoribbon such as silicon (Si), SiGe, germanium, or III-V materials like indium phosphide (InP) or gallium arsenide (GaAs). Sacrificial layers 202 include a material that can be selectively removed relative to semiconductor layers 204. In some examples, for instance, semiconductor layers 204 are silicon and sacrificial layers 202 are SiGe, or vice-versa. In some other examples where SiGe is used in each of semiconductor layers 204 and in sacrificial layers 202, the germanium concentration is different between semiconductor layers 204 and sacrificial layers 202, so as to allow for etch selectivity. For example, semiconductor layers 204 may include a higher germanium content compared to sacrificial layers 202.

While dimensions can vary from one example embodiment to the next, the thickness of each semiconductor layer 204 may be between about 5 nm and about 20 nm, in some examples. In some embodiments, the thickness of each semiconductor layer 204 is substantially the same (e.g., within 1 nm). The thickness of each of sacrificial layers 202 may be about the same as the thickness of each semiconductor layer 204 (e.g., about 5-20 nm). Each of semiconductor layers 204 and sacrificial layers 202 may be deposited using any material deposition technique, such as chemical vapor deposition (CVD), plasma-enhanced chemical vapor deposition (PECVD), physical vapor deposition (PVD), or atomic layer deposition (ALD), or epitaxial growth.

Figures 3A and 3B depict the cross-section views of the structure shown in Figures 2A and 2B, respectively, following the formation of a cap layer 302 and the subsequent formation of fins beneath cap layer 302, according to an embodiment. Cap layer 302 may be any suitable hard mask material such as a carbon hard mask (CHM) or silicon nitride. Cap layer 302 is patterned into rows to form corresponding rows of fins from the alternating layer stack of sacrificial layers 202 and semiconductor layers 204. Cap layer 302 extends along the top of each fin in a first direction, as seen in Figure 3A.

According to some embodiments, an anisotropic etching process through the layer stack continues into at least a portion of substrate 201. Portions of substrate 201 beneath the fins are not etched and yield subfin regions 304 as illustrated in Figure 3A. The etched portions of substrate 201 that are not under the fins may be filled with a dielectric fill 306 that acts as shallow trench isolation (STI) between adjacent fins as illustrated in Figure 3B. Dielectric fill 306 may be any suitable dielectric material such as silicon dioxide. Subfin regions 304 represent remaining portions of substrate 201 flanked by dielectric fill 306, according to some embodiments.

Figures 4A and 4B depict cross-section views of the structures shown in Figures 3A and 3B following the formation of sacrificial gates 402 and spacer structures 404, according to some embodiments. A gate masking layer may first be patterned in strips that extend orthogonally across each of the fins (e.g., in a second direction) in order to form corresponding sacrificial gates 402 in strips beneath the gate masking layers. Afterwards, the gate masking layers may be removed or may remain as a cap layer above each sacrificial gate 402. According to some embodiments, the sacrificial gate material is removed in all areas not protected by the gate masking layers. Sacrificial gate 402 may be any suitable material that can be selectively removed without damaging the semiconductor material of the fins. In some examples, sacrificial gate 402 includes polysilicon.

According to some embodiments, spacer structures 404 are formed along the sidewalls of sacrificial gates 402. Spacer structures 404 may be conformally deposited (e.g., CVD or ALD)_and then etched back or otherwise removed (e.g., via anisotropic or directional etch) from horizontal surfaces, such that spacer structures 404 remain mostly only on sidewalls of any exposed structures. The width of spacer structures 404 (along the first direction) may vary from one example to the next, but in some cases is in the range of 3 nm to 20 nm. According to some embodiments, spacer structures 404 may be any suitable dielectric material, such as silicon nitride, silicon carbon nitride, or silicon oxycarbonitride. In one such embodiment, spacer structures 404 comprise a nitride and dielectric fill 306 comprises an oxide, so as to provide a degree of etch selectivity during final gate processing. Other etch selective dielectric schemes (e.g., oxide/carbide, carbide/nitride) can be used as well for spacer structures 404 and dielectric fill 306. In other embodiments, spacer structures 404 and dielectric fill 306 are compositionally the same or otherwise similar, where etch selectivity is not employed.

Figures 5A and 5B depict cross-section views of the structures shown in Figures 4A and 4B following the removal of exposed portions of the fins not protected by sacrificial gates 402 and spacer structures 404, according to some embodiments. The exposed fin portions may be removed using any anisotropic etching process, such as reactive ion etching (RIE) or other directional etch process. The removal of the exposed fin portions creates source or drain trenches that alternate with gate trenches (currently filled with sacrificial gates 402) along the first direction, according to some embodiments. In some embodiments, at least a portion of subfin regions 304 is also removed such that a top surface of subfin regions 304 is recessed below a top surface of dielectric fill 306. The recessed area above subfin regions 304 may be filled with one or more dielectric materials.

Figures 6A and 6B depict cross-section views of the structures shown in Figures 5A and 5B following the formation of semiconductor liner 602, according to some embodiments. Semiconductor liner 602 may be epitaxially grown on the exposed ends of the fins (e.g., at the ends of both semiconductor layers 204 and sacrificial layers 202) and on any exposed portion of subfin 304. Semiconductor liner 602 may be the same semiconductor material as semiconductor layers 204. According to some embodiments, semiconductor liner 602 has a high etch selectivity compared with the semiconductor material of sacrificial layers 202. In one example, sacrificial layers 202 are silicon germanium and semiconductor liner 602 is silicon. The thickness of semiconductor liner 602 can vary from one example to the next, but in some cases is in the range of 1 to 5 nm. In some example cases, an additional margin of thickness in semiconductor liner 602 may be provided, given that the subsequent selective etch to remove sacrificial layers 202 may, albeit at a much slower rate, also remove some of semiconductor liner 602. So, the initially deposited thickness of semiconductor liner 602 may be set higher than the desired final thickness of layer 602. In some cases, for instance, the initial thickness of semiconductor liner 602 is set at 3 nm, and the final thickness is 1 or 2 nm. Other final thicknesses may be used as well. Factors to consider include, for instance, the amount of sacrificial material from sacrificial layers 202 to be removed, and the etch selectivity between layers 202 and 204. In some cases, semiconductor liner 602 is conformally deposited, for instance, via CVD or ALD. The epitaxial deposition is selective, in that the semiconductor liner 602 only grows on exposed semiconductor material, such as the exposed ends of semiconductor layers 204 and sacrificial layers 202 and subfin 304.

Figures 7A and 7B depict cross-section views of the structure shown in Figures 6A and 6B, respectively, following the formation of source or drain regions 702 within the source/drain trenches, according to some embodiments. Source or drain regions 702 may be formed in the areas that had been previously occupied by the exposed fins between spacer structures 404. According to some embodiments, source or drain regions 702 are epitaxially grown on semiconductor liner 602. In some example embodiments, source or drain regions 702 are n-type source or drain regions (e.g., epitaxial silicon with n-type dopants) or p-type source or drain regions (e.g., epitaxial SiGe with p-type dopants).

According to some embodiments, a dielectric liner 704 may be formed over source or drain regions 702 within the source/drain trench. Dielectric liner 704 also forms along the sidewalls of the source/drain trench above source or drain regions 702 (e.g., on outer sidewalls of spacer structures 404). Dielectric liner 704 may be any suitable dielectric material, such as silicon nitride. In some examples, dielectric liner 704 is the same dielectric material as spacer structures 404.

According to some embodiments, a dielectric fill 706 is provided between adjacent source or drain regions 702 along a given source/drain trench running in the second direction. Dielectric fill 706 may also be formed above source or drain regions 702. In some examples, dielectric fill 706 occupies a remaining volume within the source/drain trench around and over portions of source or drain regions 702. Dielectric fill 706 may be any suitable dielectric material, such as silicon dioxide. In some examples, dielectric fill 706 extends up to and planar with a top surface of spacer structures 404 (e.g., following a polishing procedure).

Figures 8A and 8B depict cross-section views of the structure shown in Figures 7A and 7B, respectively, following the removal of sacrificial gates 402 and sacrificial layers 202, according to some embodiments. In examples where gate masking layers are still present, they may be removed at this time. Once sacrificial gates 402 are removed, the fins extending between spacer structures 404 are exposed.

In the example where the fins include alternating sacrificial layers 202 and semiconductor layers 204, sacrificial layers 202 are selectively removed to leave behind nanoribbons 802 that extend between corresponding source or drain regions 702. Both ends of nanoribbons 802 directly contact semiconductor liner 602, according to some embodiments. Each vertical set of nanoribbons 802 represents the semiconductor region (also called channel region) of a different semiconductor device. It should be understood that nanoribbons 802 may also be nanowires or nanosheets. Sacrificial gates 402 and sacrificial layers 202 may be removed using the same isotropic etching process or different isotropic etching processes. Note that the presence of semiconductor liner 602 protects source or drain regions 702 during the removal of sacrificial layers 202.

Figures 9A and 9B depict cross-section views of the structure shown in Figures 8A and 8B, respectively, following the formation of a gate dielectric 902 and a gate electrode 904 on gate dielectric 902, according to some embodiments. Gate dielectric 902 may be formed around nanoribbons 802 and along any exposed surfaces within the gate trenches, such as along sidewalls of spacer structures 404 and directly on semiconductor liner 602 between nanoribbons 802. Gate dielectric 902 may include any suitable dielectric material (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, gate dielectric 902 includes a layer of hafnium oxide with a thickness between about 1 nm and about 5 nm. In some embodiments, gate dielectric 902 may include one or more silicates (e.g., titanium silicate, tungsten silicate, niobium silicate, and silicates of other transition metals). In some cases, gate dielectric 902 includes a first layer on nanoribbons 802, and a second layer on the first layer. The first layer can be, for instance, an oxide of the semiconductor material of nanoribbons 802 (e.g., silicon dioxide) and the second layer can be a high-k dielectric material (e.g., hafnium oxide or aluminum oxide). Any excess gate dielectric may be removed from the top surface of the structure, for instance, via a polishing process (e.g., chemical mechanical polishing, CMP).

The one or more conductive layers that make up gate electrode 904 may be deposited using electroplating, electroless plating, CVD, PECVD, ALD, or PVD, to name a few examples. In some embodiments, gate electrode 904 includes doped polysilicon, a metal, or a metal alloy. Example suitable metals or metal alloys include aluminum, tungsten, cobalt, molybdenum, ruthenium, titanium, tantalum, copper, and carbides and nitrides thereof. Gate electrode 904 may include, for instance, a metal fill material along with one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates.

According to some embodiments, portions of dielectric fill 706 may be removed over source or drain regions 702 and a portion of dielectric liner 704 on the top surface of source or drain regions 702 is also removed to expose the top surface of source or drain regions 702. Contacts 906 may be formed on the top surfaces of source or drain regions 702. Contacts 906 may include any suitable conductive material, such as tungsten, cobalt, molybdenum, or ruthenium, for making electrical contact with the underlying source or drain regions 702.

Since there are no dielectric spacer structures between nanoribbons 802, the gate structure extends along the first direction at a first length L₁ beneath spacer structures 404. In some examples, the gate structure extends along the first direction between semiconductor liner 602 and contacts semiconductor liner 602 at both ends of the gate structure. The gate structure may extend along the first direction at a different length L₂ between spacer structures 404. In some examples, L₁ is between about 15 nm and about 40 nm and L₂ is between about 10 nm and about 25 nm. Also, note in the channel region between the source and drain regions 702 how the sides of nanoribbons 802 are substantially coplanar with the side of the gate structure. In this particular example, the sides of nanoribbons 802 are substantially coplanar with the outer surface of the gate dielectric 902 that lines portions of the gate trench walls.

Figures 10A and 10B depict cross-section views of the structure shown in Figures 9A and 9B, respectively, following the formation of a gate cap 1002, according to some embodiments. Top portions of gate electrode 904 may be recessed using any suitable metal etch process with the recessed areas being filled with a dielectric material to form gate cap 1002. Accordingly, gate cap 1002 may be any suitable dielectric material, such as silicon nitride. In some examples, gate cap 1002 includes the same dielectric material as spacer structures 404. Other examples may not include gate cap 1002.

Figure 11 illustrates an example embodiment of a chip package 1100, in accordance with an embodiment of the present disclosure. As can be seen, chip package 1100 includes one or more dies 1102. One or more dies 1102 may include at least one integrated circuit having semiconductor devices, such as any of the semiconductor devices disclosed herein. One or more dies 1102 may include any other circuitry used to interface with other devices formed on the dies, or other devices connected to chip package 1100, in some example configurations.

As can be further seen, chip package 1100 includes a housing 1104 that is bonded to a package substrate 1106. The housing 1104 may be any standard or proprietary housing, and may provide, for example, electromagnetic shielding and environmental protection for the components of chip package 1100. The one or more dies 1102 may be conductively coupled to a package substrate 1106 using connections 1108, which may be implemented with any number of standard or proprietary connection mechanisms, such as solder bumps, ball grid array (BGA), pins, or wire bonds, to name a few examples. Package substrate 1106 may be any standard or proprietary package substrate, but in some cases includes a dielectric material having conductive pathways (e.g., including conductive vias and lines) extending through the dielectric material between the faces of package substrate 1106, or between different locations on each face. In some embodiments, package substrate 1106 may have a thickness less than 1 millimeter (e.g., between 0.1 millimeters and 0.5 millimeters), although any number of package geometries can be used. Additional conductive contacts 1112 may be disposed at an opposite face of package substrate 1106 for conductively contacting, for instance, a printed circuit board (PCB). One or more vias 1110 extend through a thickness of package substrate 1106 to provide conductive pathways between one or more of connections 1108 to one or more of contacts 1112. Vias 1110 are illustrated as single straight columns through package substrate 1106 for ease of illustration, although other configurations can be used (e.g., damascene, dual damascene, through-silicon via, or an interconnect structure that meanders through the thickness of substrate 1106 to contact one or more intermediate locations therein). In still other embodiments, vias 1110 are fabricated by multiple smaller stacked vias, or are staggered at different locations across package substrate 1106. In the illustrated embodiment, contacts 1112 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 1112, to inhibit shorting.

In some embodiments, a mold material 1114 may be disposed around the one or more dies 1102 included within housing 1104 (e.g., between dies 1102 and package substrate 1106 as an underfill material, as well as between dies 1102 and housing 1104 as an overfill material). Although the dimensions and qualities of the mold material 1114 can vary from one embodiment to the next, in some embodiments, a thickness of mold material 1114 is less than 1 millimeter. Example materials that may be used for mold material 1114 include epoxy mold materials, as suitable. In some cases, the mold material 1114 is thermally conductive, in addition to being electrically insulating.

### Methodology

Figure 12 is a flow chart of a method 1200 for forming at least a portion of an integrated circuit, according to an embodiment. Various operations of method 1200 may be illustrated in Figures 2A - 10A and 2B -10B. However, the correlation of the various operations of method 1200 to the specific components illustrated in the aforementioned figures is not intended to imply any structural and/or use limitations. Rather, the aforementioned figures provide one example embodiment of method 1200. Other operations may be performed before, during, or after any of the operations of method 1200. For example, method 1200 does not explicitly describe various standard processes that are usually performed to form transistor structures. Some of the operations of method 1200 may be performed in a different order than the illustrated order.

Method 1200 begins with operation 1202 where a semiconductor fin is formed, according to some embodiments. The fin may be one fin of a plurality of similar fins formed across a substrate. The fins can be formed of material deposited onto an underlying substrate. In another such example, non-native fins can be formed in a so-called aspect ratio trapping based process, where native fins are etched away so as to leave fin-shaped trenches which can then be filled with an alternative semiconductor material (e.g., group IV or III-V material). In still other embodiments, the fins include alternating layers of material (e.g., alternating layers of silicon and SiGe) that facilitates forming of nanowires and nanoribbons during a gate forming process where one type of the alternating layers are selectively etched away so as to liberate the other type of alternating layers within the channel region, so that a gate-all-around (GAA) process can then be carried out. Again, the alternating layers can be blanket deposited and then etched into fins, or deposited into fin-shaped trenches, according to some examples. The fins may also include a cap structure over each fin that is used to define the locations of the fins during, for example, an RIE process. The cap structure may be a dielectric material, such as silicon nitride.

According to some embodiments, a dielectric fill is formed around subfin portions of the one or more fins. In some embodiments, the dielectric fill extends between each pair of adjacent parallel fins and runs lengthwise in the same direction as the fins. In some embodiments, the anisotropic etching process that forms the fins also etches into a portion of the substrate and the dielectric fill may be formed within the recessed portions of the substrate. Accordingly, the dielectric fill acts as shallow trench isolation (STI) between adjacent fins. The dielectric fill may be any suitable dielectric material, such as silicon dioxide. Lower portions of the fins adjacent to the dielectric fill may be identified as the subfins.

Method 1200 continues with operation 1204 where a sacrificial gate is formed over the fin. The sacrificial gate may be one sacrificial gate of a plurality of sacrificial gates patterned using gate masking layers in strips that run orthogonally over various fins and parallel to one another (e.g., forming a cross-hatch pattern). The gate masking layers may be any suitable hard mask material, such as CHM or silicon nitride. The sacrificial gate itself may be formed from any suitable material that can be selectively removed at a later time without damaging the semiconductor material of the fin. In one example, the sacrificial gate includes polysilicon.

According to some embodiments, spacer structures are also formed on sidewalls of at least the sacrificial gate. The spacer structures may be deposited and then etched back such that the spacer structures remain mostly only on sidewalls of any exposed structures. In some cases, spacer structures may also be formed along sidewalls of the exposed fin running orthogonally between the strips of sacrificial gates. According to some embodiments, the spacer structures may be any suitable dielectric material, such as silicon nitride or silicon oxynitride.

Method 1200 continues with operation 1206 where exposed portions of the fins are removed to form source/drain trenches. Any exposed portions of the fins not covered by the sacrificial gates or spacer structures may be removed using any anisotropic etching process, such as reactive ion etching (RIE). In some examples, portions of the subfin may also be removed during this process.

Method 1200 continues with operation 1208 where a semiconductor layer is formed over sides of the semiconductor fin. The semiconductor layer may be epitaxially grown on the exposed ends of the fin (e.g., at the ends of the alternating semiconductor layers in the fin) and on any exposed portion of the subfin within the source/drain trench. According to some embodiments, the semiconductor layer has a high etch selectivity compared with the semiconductor material of sacrificial semiconductor layers within the fin. In one example, the sacrificial layers of the fin are silicon germanium and the semiconductor layer is silicon. The above relevant discussion with respect to initial and final thicknesses of the semiconductor layer is equally applicable here.

Method 1200 continues with operation 1210 where source or drain regions are formed at opposite ends of the fin on the semiconductor layer within the source/drain trenches. The source or drain regions may be formed in the areas that had been previously occupied by the exposed fin between the spacer structures. According to some embodiments, the source or drain regions are epitaxially grown from the semiconductor layer that covers the sides of the fin. In some example embodiments, the source or drain regions are NMOS source or drain regions (e.g., epitaxial silicon with n-type dopants) or PMOS source or drain regions (e.g., epitaxial SiGe with p-type dopants). A dielectric fill may be formed between and over the source or drain regions along a given source/drain trench. The dielectric fill may be any suitable dielectric material, such as silicon dioxide. In some examples, the dielectric fill extends over the source or drain regions up to and planar with a top surface of the spacer structures. The dielectric fill also acts as an electrical insulator between adjacent source or drain regions, although some adjacent source or drain regions may have merged together during their growth or may include a gate cut structure separating them.

Method 1200 continues with operation 1212 where the sacrificial gate is removed. According to some embodiments, the sacrificial gate may be removed along with any sacrificial layers within the exposed fins between the spacer structures. The sacrificial gate and/or sacrificial layers may be removed using any suitable isotropic etching process. The semiconductor layer on the outside of the fin protects the source or drain region during the removal of the sacrificial layers. The removal of the fin's sacrificial layers leaves behind semiconductor nanoribbons extending along the first direction between the source or drain regions (with ends of the nanoribbons directly contacting the semiconductor layer on the source or drain regions).

Method 1200 continues with operation 1214 where a gate structure is formed over the semiconductor nanoribbons. The gate structure may be formed in the space previously occupied by the sacrificial gate and the sacrificial layers of the fin. The gate structure may include both a gate dielectric and a gate electrode. The gate dielectric is first formed over the exposed semiconductor nanoribbons followed by forming the gate electrode within the remainder of the trench between the spacer structures, according to some embodiments. The gate dielectric also forms directly on portions of the semiconductor layer between the nanoribbons. The gate dielectric may include any number of dielectric layers deposited using a CVD process, such as ALD. The gate electrode can include any conductive material, such as a metal, metal alloy, or polysilicon. The gate electrode may be deposited using electroplating, electroless plating, CVD, ALD, PECVD, or PVD, to name a few examples.

### Example System

FIG. 13 is an example computing system implemented with one or more of the integrated circuit structures as disclosed herein, in accordance with some embodiments of the present disclosure. As can be seen, the computing system 1300 houses a motherboard 1302. The motherboard 1302 may include a number of components, including, but not limited to, a processor 1304 and at least one communication chip 1306, each of which can be physically and electrically coupled to the motherboard 1302, or otherwise integrated therein. As will be appreciated, the motherboard 1302 may be, for example, any printed circuit board (PCB), whether a main board, a daughterboard mounted on a main board, or the only board of system 1300, etc.

Depending on its applications, computing system 1300 may include one or more other components that may or may not be physically and electrically coupled to the motherboard 1302. These other components may include, but are not limited to, volatile memory (e.g., DRAM), nonvolatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1300 may include one or more integrated circuit structures or devices configured in accordance with an example embodiment (e.g., a module including an integrated circuit device on a substrate, the substrate having one or more semiconductor devices with a semiconductor layer separating gate structures from source or drain regions, as variously provided herein). In some embodiments, multiple functions can be integrated into one or more chips (e.g., for instance, note that the communication chip 1306 can be part of or otherwise integrated into the processor 1304).

The communication chip 1306 enables wireless communications for the transfer of data to and from the computing system 1300. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1306 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1300 may include a plurality of communication chips 1306. For instance, a first communication chip 1306 may be dedicated to shorter range wireless communications such as Wi-Fi and Bluetooth and a second communication chip 1306 may be dedicated to longer range wireless communications such as GPS, EDGE, GPRS, CDMA, WiMAX, LTE, Ev-DO, and others.

The processor 1304 of the computing system 1300 includes an integrated circuit die packaged within the processor 1304. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 1306 also may include an integrated circuit die packaged within the communication chip 1306. In accordance with some such example embodiments, the integrated circuit die of the communication chip includes one or more semiconductor devices as variously described herein. As will be appreciated in light of this disclosure, note that multistandard wireless capability may be integrated directly into the processor 1304 (e.g., where functionality of any chips 1306 is integrated into processor 1304, rather than having separate communication chips). Further note that processor 1304 may be a chip set having such wireless capability. In short, any number of processor 1304 and/or communication chips 1306 can be used. Likewise, any one chip or chip set can have multiple functions integrated therein.

In various implementations, the computing system 1300 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 1300 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit with one or more bodies comprising semiconductor material and extending in a first direction, a gate structure extending in a second direction over the one or more bodies, a layer having semiconductor material and extending in a third direction along a side of the one or more bodies and a side of the gate structure, and a source or drain region on the layer. The layer is between the source or drain region and the one or more bodies along the first direction, and the layer is between the source or drain region and the gate structure along the first direction.

Example 2 includes the integrated circuit of Example 1, wherein the semiconductor material of the layer comprises silicon.

Example 3 includes the integrated circuit of Example 1 or 2, wherein the layer has a thickness between about 1 nm and about 2 nm.

Example 4 includes the integrated circuit of any one of Examples 1-3, wherein the layer contacts a bottom surface of the source or drain region.

Example 5 includes the integrated circuit of any one of Examples 1-4, wherein the gate structure comprises a gate dielectric on the one or more semiconductor nanoribbons and a gate electrode on the gate dielectric, and the side of the one or more bodies is substantially coplanar with the side of the gate structure.

Example 6 includes the integrated circuit of Example 5, wherein the gate dielectric directly contacts the layer.

Example 7 includes the integrated circuit of Example 5 or 6, wherein the gate dielectric comprises a high-k dielectric material.

Example 8 includes the integrated circuit of any one of Examples 1-7, further comprising spacer structures above the one or more bodies and on sidewalls of an upper portion of the gate structure.

Example 9 includes the integrated circuit of Example 8, wherein the gate structure extends beneath the spacer structures along the first direction.

Example 10 includes the integrated circuit of any one of Examples 1-9, wherein the one or more bodies comprise germanium, silicon, or a combination thereof.

Example 11 includes the integrated circuit of any one of Examples 1-10, wherein the one or more bodies are a plurality of nanoribbons or nanowires or nanosheets.

Example 12 includes the integrated circuit of any one of Examples 1-11, wherein the semiconductor material of the one or more bodies and the semiconductor material of the layer are the same semiconductor material.

Example 13 includes the integrated circuit of any one of Examples 1-11, wherein the semiconductor material of the one or more bodies is elementally different from the semiconductor material of the layer.

Example 14 includes the integrated circuit of any one of Examples 1-13, wherein the one or more bodies, the gate structure, the layer, and the source or drain region are all part of a gate-all-around transistor or a forksheet transistor.

Example 15 is a printed circuit board including the integrated circuit of any one of Examples 1-14.

Example 16 is an electronic device that includes a chip package having one or more dies. At least one of the one or more dies includes a semiconductor device having one or more semiconductor nanoribbons extending in a first direction, a source or drain region, and a gate structure extending in a second direction over the one or more semiconductor nanoribbons, and a semiconductor layer extending in a third direction along a side of the one or more semiconductor nanoribbons and a side of the gate structure. The side of the one or more semiconductor nanoribbons are substantially coplanar with the side of the gate structure. The semiconductor layer is between the source or drain region and the one or more semiconductor nanoribbons along the first direction, and the semiconductor layer is between the source or drain region and the gate structure along the first direction.

Example 17 includes the electronic device of Example 16, wherein the semiconductor layer comprises silicon.

Example 18 includes the electronic device of Example 16 or 17, wherein the semiconductor layer has a thickness between about 1 nm and about 2 nm.

Example 19 includes the electronic device of any one of Examples 16-18, wherein the semiconductor layer contacts a bottom surface of the source or drain region.

Example 20 includes the electronic device of any one of Examples 16-19, wherein the gate structure comprises: a gate dielectric on the one or more semiconductor nanoribbons; and a gate electrode on the gate dielectric.

Example 21 includes the electronic device of Example 20, wherein the gate dielectric directly contacts the semiconductor layer.

Example 22 includes the electronic device of Example 20 or 21, wherein the gate dielectric comprises a high-k dielectric material.

Example 23 includes the electronic device of any one of Examples 16-22, wherein the at least one of the one or more dies further comprises spacer structures on sidewalls of at least a top portion of the gate structure.

Example 24 includes the electronic device of Example 23, wherein the gate structure extends beneath the spacer structures along the first direction.

Example 25 includes the electronic device of any one of Examples 16-24, wherein the one or more semiconductor nanoribbons comprise germanium, silicon, or a combination thereof.

Example 26 includes the electronic device of any one of Examples 16-25, further comprising a printed circuit board, wherein the chip package is coupled to the printed circuit board.

Example 27 is a method of forming an integrated circuit that includes forming a fin comprising layers of first semiconductor material alternating with layers of second semiconductor material, the fin extending above a substrate and extending lengthwise along a first direction; forming a semiconductor layer over sidewalls of the fin; forming source or drain regions on the semiconductor layer at the sidewalls of the fin; removing the layers of second semiconductor material from the fin; and forming a gate structure extending in a second direction over the layers of first semiconductor material, wherein the gate structure contacts the semiconductor layer.

Example 28 includes the method of Example 27, wherein the semiconductor layer has a semiconductor material that is different than the layers of second semiconductor material.

Example 29 includes the method of Example 27 or 28, wherein the semiconductor layer comprises silicon and the layers of second semiconductor material comprise silicon and germanium.

Example 30 includes the method of any one of Examples 27-29, wherein forming the gate structure comprises forming a gate dielectric on the layers of first semiconductor material and on the semiconductor layer, and forming a gate electrode on the gate dielectric.

Example 31 includes the method of any one of Examples 27-30, wherein forming the semiconductor layer comprises epitaxially growing the semiconductor layer on the sidewalls of the fin.

Example 32 is an integrated circuit that includes a first body of semiconductor material and a second body of semiconductor each extending in a first direction, a gate structure extending in a second direction over the first and second bodies, a first layer of semiconductor material extending in a third direction along a first side of each of the first and second bodies and a first side of the gate structure, and a second layer of semiconductor material extending in the third direction along a second side of each of the first and second bodies and a second side of the gate structure. The gate structure extends along the first direction between the first layer and the second layer and contacts both the first layer and the second layer.

Example 33 includes the integrated circuit of Example 32, wherein the first and second layers each comprise silicon.

Example 34 includes the integrated circuit of Example 32 or 33, wherein the first and second layers each has a thickness between about 1 nm and about 2 nm.

Example 35 includes the integrated circuit of any one of Examples 32-34, further comprising a first source or drain region on the first layer and a second source or drain region on the second layer.

Example 36 includes the integrated circuit of Example 35, wherein the first layer contacts a bottom surface of the first source or drain region, and the second layer contacts a bottom surface of the second source or drain region.

Example 37 includes the integrated circuit of any one of Examples 32-36, wherein the gate structure comprises: a gate dielectric on the first and second bodies; and a gate electrode on the gate dielectric.

Example 38 includes the integrated circuit of Example 37, wherein the gate dielectric directly contacts both the first layer and the second layer.

Example 39 includes the integrated circuit of Example 37 or 38, wherein the gate dielectric comprises a high-k dielectric material.

Example 40 includes the integrated circuit of any one of Examples 32-39, further comprising spacer structures on sidewalls of at least a top portion of the gate structure.

Example 41 includes the integrated circuit of Example 40, wherein the gate structure extends beneath the spacer structures along the first direction.

Example 42 includes the integrated circuit of any one of Examples 32-41, wherein each of the first and second bodies is a nanoribbon or nanowire or nanosheet that comprises germanium, silicon, or a combination thereof.

Example 43 includes the integrated circuit of any one of Examples 32-42, wherein the semiconductor material of the first body, the semiconductor material of the second body, the semiconductor material of the first layer, and the semiconductor material of the second layer are the same semiconductor material.

Example 44 includes the integrated circuit of any one of Examples 32-42, wherein the semiconductor material of the first body is elementally different from the semiconductor material of the first layer.

Example 45 includes the integrated circuit of any one of Examples 32-44, wherein the first and second bodies, the gate structure, and the first and second layers are all part of a gate-all-around transistor or a forksheet transistor.

Example 46 is a printed circuit board including the integrated circuit of any one of Examples 32-45.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
one or more bodies comprising semiconductor material and extending in a first direction;
a gate structure extending in a second direction over the one or more bodies;
a layer comprising semiconductor material and extending in a third direction along a side of the one or more bodies and a side of the gate structure; and
a source or drain region on the layer, such that the layer is between the source or drain region and the one or more bodies along the first direction, and the layer is between the source or drain region and the gate structure along the first direction.

2. The integrated circuit of claim 1, wherein the semiconductor material of the layer comprises silicon.

3. The integrated circuit of claim 1 or 2, wherein the layer has a thickness between about 1 nm and about 2 nm.

4. The integrated circuit of any one of claims 1 through 3, wherein the layer contacts a bottom surface of the source or drain region.

5. The integrated circuit of any one of claims 1 through 4, wherein the gate structure comprises a gate dielectric on the one or more semiconductor nanoribbons and a gate electrode on the gate dielectric, and the side of the one or more bodies is substantially coplanar with the side of the gate structure.

6. The integrated circuit of claim 5, wherein the gate dielectric directly contacts the layer.

7. The integrated circuit of claim 5 or 6, wherein the gate dielectric comprises a high-k dielectric material.

8. The integrated circuit of any one of claims 1 through 7, further comprising spacer structures above the one or more bodies and on sidewalls of an upper portion of the gate structure.

9. The integrated circuit of claim 8, wherein the gate structure extends beneath the spacer structures along the first direction.

10. The integrated circuit of any one of claims 1 through 9, wherein the one or more bodies comprise germanium, silicon, or a combination thereof.

11. The integrated circuit of any one of claims 1 through 10, wherein the one or more bodies are a plurality of nanoribbons or nanowires or nanosheets.

12. The integrated circuit of any one of claims 1 through 11, wherein the semiconductor material of the one or more bodies and the semiconductor material of the layer are the same semiconductor material.

13. The integrated circuit of any one of claims 1 through 10, wherein the semiconductor material of the one or more bodies is elementally different from the semiconductor material of the layer.

14. The integrated circuit of any one of claims 1 through 13, wherein the one or more bodies, the gate structure, the layer, and the source or drain region are all part of a gate-all-around transistor or a forksheet transistor.

15. A printed circuit board including the integrated circuit of any one of claims 1 through 14.
